# EUROPEAN PATENT SPECIFICATION

(11) **EP 2 231 685 B1**
(45) Date of publication and mention of the grant of the patent: **15.02.2012**
(21) Application number: 07861195.1
(22) Date of filing: 17.12.2007
(51) Int. Cl.: C07F 15/00, H01G 9/20, H01L 51/00

(54) **NOVEL RUTHENIUM COMPLEX PHOTO-SENSITIZERS FOR DYE SENSITIZED SOLAR CELLS**
NEUE RUTHENIUMKOMPLEXE ALS FOTOSENSIBILISIERENDE SUBSTANZEN FÜR FARBSTOFFSENSIBILISIERTE SOLARZELLEN
NOUVEAUX PHOTOSENSIBILISATEURS COMPLEXES DE RUTHÉNIUM POUR CELLULES SOLAIRES SENSIBILISÉES PAR UN COLORANT

(43) Date of publication of application: 29.09.2010
(73) Proprietor: Türkiye Sise Ve Cam Fabrikalari A.S., 34330 Istanbul (TR)
(72) Inventor: ICLI, Siddik, 35100 Izmir (TR); ZAFER, Ceylan, 35100 Izmir (TR); OCAKOGLU, Kasim, 35100 Izmir (TR); TEOMAN, Yildirim, 34330 Istanbul (TR)
(74) Representative: Yavuzcan, Alev
(86) International application number: PCT/TR2007/000149
(87) International publication number: WO 2009/078823

(56) References cited:
- WO-A-99/40424
- US-A1- 2007 000 539
- ARANGIBIA A ET AL: "Synthesis and characterization of new ruthenium complexes with 11-carboxy-dipyrido(3,2-a:2',3'-c)phenazin e as ligand" BOLETIN DE LA SOCIEDAD CHILENA DE QUIMICA, vol. 45, no. 4, 2000, pages 587-592, XP002407813 ISSN: 0366-1644
- OCAKOGLU ET AL: "Synthesis, characterization, electrochemical and spectroscopic studies of two new heteroleptic Ru(II) polypyridyl complexes" DYES AND PIGMENTS, vol. 75, no. 2, 10 May 2007 (2007-05-10), pages 385-394, XP022069947 ISSN: 0143-7208
- ONO, KATSUHIKO ET AL: "A dye-sensitized solar cell using a red ruthenium(II) complex with 9,9-bis(4-methoxyphenyl)- 4,5-diazafluorene" CHEMISTRY LETTERS, vol. 36, no. 7, 2007, pages 892-893, XP008096078 ISSN: 0366-7022

## Description

### BACKGROUND OF THE INVENTION

This invention relates to novel ruthenium complex photo-sensitizers and their use in dye sensitized solar cells comprising nanocrystalline metal oxide film sensitized with these dyes.

Ruthenium (II) bipyridyl complexes have been extensively studied as a result of their remarkable chemical stability and photophysical properties. These chromophores have found to be used in a wide variety of applications, from solar energy related research to molecular wires, sensors and switches, machines and also as therapeutic agents. Ruthenium polypyridyl sensitizers have been the first choice in view of the extensive knowledge available. Metal-to-ligand charge transfer (MLCT) transitions dominate their visible light absorption and many of their photophysical and redox behaviors in such complexes. The metal-to-ligand charge transfer absorption can be extended to longer wavelengths by appropriate substituent changes on chromophoric ligands. The major focus of this study has been to investigate electron injection performances of these complexes onto metal oxides, in view of their use as photosensitizers, for example, in photoelectrochemical solar cells. However, different ligands are chosen due to their different electrochemical properties. These special ligands have several distinct properties compared to its analogue 2,2'-bipyridine. There have been few reports on the synthesis and characterization of heteroleptic complexes of ruthenium. In a study of "Ocakoglu et al.. "Sysntheis, characterization, electomechanical and spectroscopic studies of two new heteroleptic RU(II) polypyridyl complexes" DYES And Pigments, vol. 75, no. 2 10 May 2007, it is reported that the synthesis and characterization of new sensitizers K27 and K30 using a novel synthetic route and a systematic study of their emission, electrochemical, and photo-electrochemical properties.
The reference describes the novel synthetic route of one pot synthesis of ruthenium complexes which was used on the synthesis of novel dyes K45 and K47. The synthetic procedure of K45 and K47 described in the patent application is becomes different in the second step of synthesis where,5-diazafluoren-9-one ligand reacts with triethylenglycol to get a product K45 and N-(3-aminopropyl) imidazole to get a product K47. The final products K45 and K47 are completely different from the ruthenium complexes K27 and K30 reported in the reference paper.

The synthetic methodology of such heteroleptic complexes involves several steps, resulting in very low yields. The present application discloses the synthesis and characterization of such new sensitizers using a different synthetic routes with high yield and a systematic study of their photovoltaic properties.

Photoactive dyes anchored on metal oxide layers serve as solar cells. It is known that adsorbed dyes on metal oxide are capable to absorb light in the visible region and increasing energy conversion. Energy conversion efficiency is directly related with the overlap of the absorption band of the photosensitizer with solar spectrum.

Dye-sensitized solar cells (DSSCs) based on TiO₂ photoelectrode have been attracting considerable attention since Grätzel et al. [Gratzel et al: Bai, Yu; Cao, Yiming; Zhang, Jing; Wang, Mingkui; Li, Renzhi; Wang, Peng; Zakeeruddin, Shaik M.; Grätzel, Michael (2008). "High-performance dye-sensitized solar cells based on solvent-free electrolytes produced from eutectic melts". Nature Materials 7 (8): 626.] reported high solar energy to electricity conversion efficiency, η, up to 11 % with ruthenium bipyridyl dyes. With this new technology, fabrication process is simple and production cost is low in comparison with the silicon technology. In recent years various Ru-complexes have been used as efficient photosensitizers.

### SUMMARY OF THE INVENTION

This invention relates to novel ruthenium complex photo-sensitizers which can efficiently absorb solar light in the visible region and photo-electrochemical solar cell comprising fine semiconductor particles sensitized with these photo-sensitizers.

Photosensitizers described in this invention were represented by three different general formulas because of their different chemical and photo-physical properties.

### DETAILED DESCRIPTION OF THE INVENTION

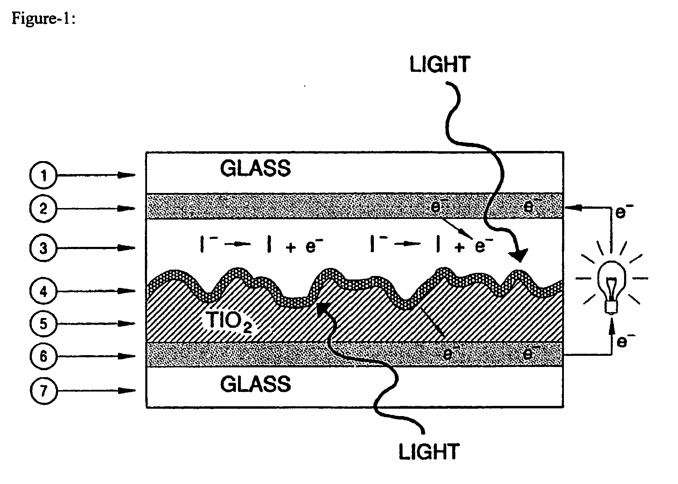

Figure 1 shows the Dye sensitized photo electrochemical solar cell structure.
Figure 2 shows the Current-Voltage (I-V) curves and Incident Photon to Current Conversion Efficiency (IPCE) spectra of the dye sensitized solar cells (DSSC) using novel sensitizer dyes described in this invention.

Solar cell structure shown in figure-1 comprise of 7 (seven) layers. Numerals used in the drawings are explained below :
1 and 7 are Glass or polymer substrates
2 is the Pt catalyst coated Transparent conductive oxide (TCO) layer (Florine dopped tin oxide, FTO; Tin dopped indium oxide, ITO; Aluminum dopped zinc oxide, AZO) 6 is the transparent conductive oxide (TCO) layer (Florine dopped tin oxide, FTO; Tin dopped indium oxide, ITO; Aluminum dopped zinc oxide, AZO)
3 is the Electrolyte including redox couple
4 is the chemically bonded dye monolayer adsorbed on mesoporous nanocrystalline TiO₂ layer preferably
5 is the mesoporous nanocrystalline TiO₂ layer
   FIGURE-2 shows Current-Voltage (I-V) curves and Incident Photon to Current Conversion Efficiency (IPCE) spectra of the dye sensitized solar cells (DSSC).

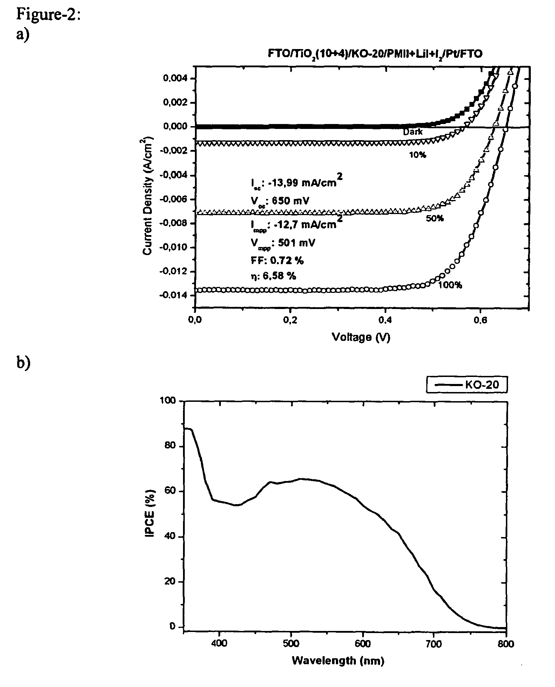

   Figure 2a is the I-V curve of K-20 sensitized photoelectrochemical solar cell
   Figure 2b is the IPCE spectrum of K-20 sensitized photoelectrochemical solar cell

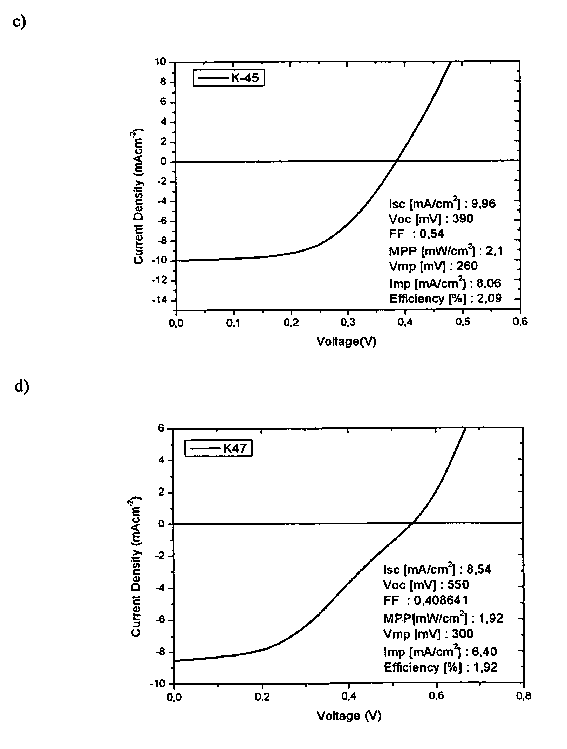

   Figure 2c is the I-V curve of K-45 sensitized photoelectrochemical solar cell
   Figure 2d is the I-V curve of K-47 sensitized photoelectrochemical solar cell

Ruthenium complexes described in the present invention represented by the formula-1,
[RuL¹L²X₂]₂ is K20 (Bis[Ru^{II}(4,4-dicarboxy-2,2-bipyridyl)-di(thiocyanate)]-[3,3',5,5'-tetramethyl-*N*⁴,*N*⁴-di(5*H-*pyrido[3',2':4,5]cyclopenta[1,2-*b*]pyridin-5-ylidene)[1,1'-biphenyl]-4,4'-diamine]), 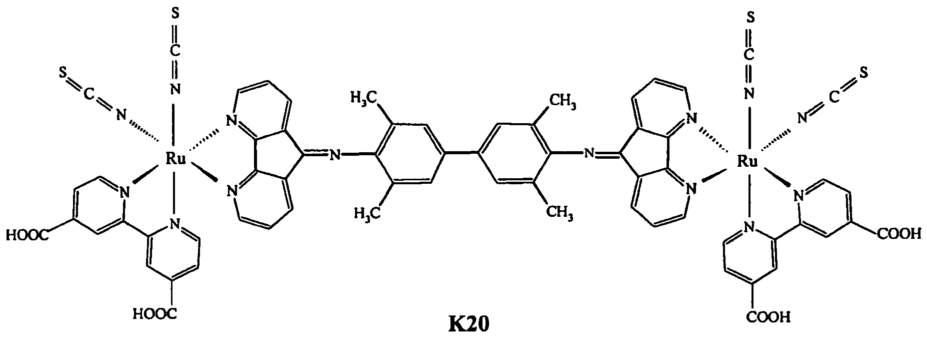 where L1 is 4,4'-dicarboxy-2,2'-bipyridine, L2 is [3,3',5,5'-tetramethyl-*N*⁴,*N*⁴-di(5*H-*pyrido[3',2':4,5]cyclopenta[1,2-b]pyridin-5-ylidene)[1,1'-biphenyl]-4,4'-diamine] and X is isothiocyanide.

K20 is dimmer structure and the aim of this structure is to increase absorption coefficient of dye by extended pi-conjugation and double core. As expected the molar extinction coefficient of K20 was measured as ε = 22000 M⁻¹cm⁻¹. In comparison with the most efficient dyes N719 and Z907 reported by Graetzel et al. the molar extinction coefficient of K20 is two times higher.

Electrochemical measurements were done to determine the HOMO and LUMO of K20. The HOMO is -5.71 eV and LUMO is -3. 82 eV. These redox potentials are appropriate for electron transfer to nanocrystalline TiO₂ (5) conduction band.

Two novel ruthenium complexes described in the present invention represented by the formula-2, RuL¹L²X_{2.} The first ruthenium complex with the general formula-2, is K45 (Ru^{II} (spiro[4,5-diazafluorene-9,1'-[2,5,8,11]tetraoxacycloundecane])(4,4-dicarboxy-2,2 -bipyridyl)-di(thiocyanate)), 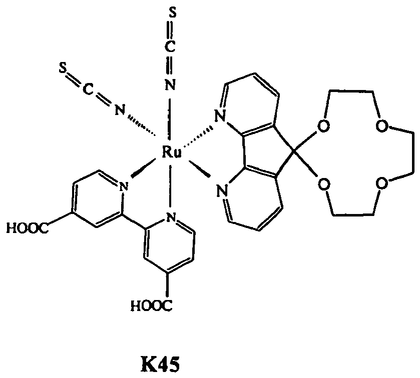 where L1 is 4,4'-dicarboxy-2,2'-bipyridine, L2 is spiro[4,5-diazafluorene-9,1'-[2,5,8,11]tetraoxacycloundecane] compound and X is isothiocyanide. K45 includes an ion coordinating crown ether group. This group is capable to coordinate Li⁺ ion. This is important for dye sensitized solar cell application. Especially for solid state solar cell Li⁺ ion concentration is critical for conductivity of hole transport layer. Additionally, lithium ions increase the stability of holes and reduce the charge recombination. Coordinating the lithium ions to the sensitizer rather than mixing in the bulk gives better results in photovoltaic measurements. The reduction and oxidation potentials of K45 was determined by cyclic voltammetric measurement. The HOMO is -5,47 eV and the LUMO is -3,59 eV.

The second ruthenium complex with the general formula-2, is K47(Ru^{II}(3-(3-butyl-2-iodo-2,3-dihydro-1*H*-imidazol-1-yl)-*N-*(5*H*-pyrido[3',2':4,5]cyclopenta[1,2-*b*]pyridin-5-ylidene)-1-propanamine)(4,4'-dicarboxy-2,2 -bipyridyl)-di(thiocyanate), 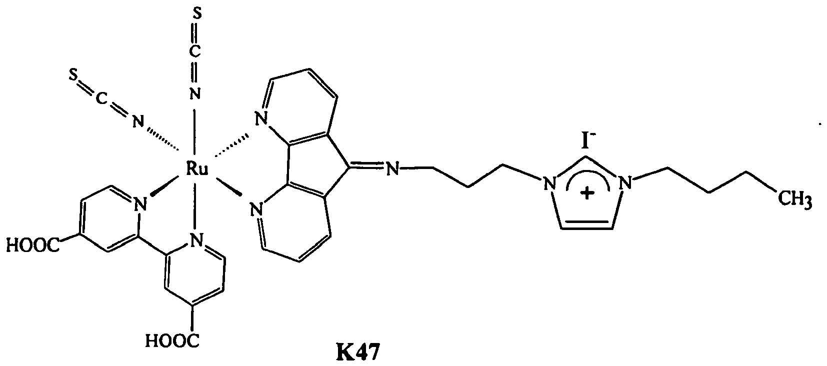 where L1 is 4,4'-dicarboxy-2,2'-bipyridine, L2 is N-5H-pyrido[3',2':4,5]cyclopenta[1,2-bipyridin-5-ylidene-3-(3-butyl-2,3-dihydro-1H-pyrrole-1-yl)propan-1-amin and X is isothiocyanide. K47 is specially designed and synthesized for liquid electrolyte (3) containing dye sensitized solar cells. The cation of the redox couple was chemically bounded to sensitizer dye (4) via propyl chain. The aim of the synthesis of this dye is to control the distance between the redox couple (3) and dye (4) to control the charge recombination. The HOMO of the dye is measured as -5,41 and the LUMO is -3,52 eV.

### Synthesis procedure of KO-20:

**Preparation of [3,3',5,5'-tetramethyl- *N⁴,N^{4'}-*di(5*H*-pyrido[3',2':4,5] cyclopenta [1,2-*b*]pyridin-5-ylidene)[1,1'-biphenyl]-4,4'-diamine] [L1]**: A mixture of 4,5-diazafluoren-9-one (555 mg, 3.05 mmol) and 3,3,5,5-tetramethylene benzidine (336mg, 1.4 mmol) was refluxed in glacial acidic acid (5 mL) for an hour. After the solution was cooled to room temperature, the solid was removed by suction - filtration, washed with water, then methanol and dried under vacuum. The solid was re-crystallized from CH₂Cl₂ / hexane. 620 mg, 78% yield. Anal. Calc. For C₃₈H₂₈N₆: C, 80.26; H, 4.96; N, 14.78. Found: C, 8.11; H, 4.81; N, 14.09%. FT-IR (KBr, cm⁻¹): 2918, 2849, 1654, 1570, 1400, 859, 751. ¹H NMR (CDCl₃) δ ppm: 8.85 (d, J= 4 Hz, 2H, NC*H*CH), 8.69 (d, *J* = 4 Hz, 2H, NC*H*CH), 8.38 (d, *J =* 6 Hz, 2H, CHC*H*C), 7.48 (s, 4H, CC*H*C), 7.45 (q, *J =* 5.2 Hz, 2H, CHC*H*CH), 7.05 (q, *J* = 5.2 Hz, 2H, CHC*H*CH), 6.95 (d, *J* = 6.8 Hz, 2H, CHC*H*C), 2.12 (s, 12H, Ar-C*H₃*). ¹³C NMR δ ppm: 161.6 (C*C*NC), 153.4 (N*C*HCH), 148.5 (CN*C*), 143.1 (N*CC*N), 136.9 (CHCHC), 132.9 (*C*-*C*), 132.5 (H₃C*C*), 130.9 (*C*CN), 130.4 (CCN), 126.9 (H₃CC*C*HC), 125.7 (CH*C*HCH), 18.4 (C*C*H₃).

**Synthesis** of **[Ru₂(L1)Cl₄(dmso)₄]:** RuCl₂(dmso)₄ (510 mg, 1.05 mmol) was dissolved in chloroform (100 mL), and to this solution was added (268 mg, 0.5 mmol) L1. The reaction mixture was refluxed under argon for 1 h. After allowing it to cool to (25 °C) room temperature, it was filtered through a sintered (G4) glass crucible. The filtrate was evaporated completely, and the resulting solid was redissolved in acetone in order to remove unrelated RuCl₂(dmso)₄. Precipitation of the complex with diethyl ether resulted a fine orange - yellow solid that was filtered and dried under vacuum. 536 mg, 85% yield. Anal. Calc. For C₄₆H₅₂N₆O₄S₄Ru₂Cl₄.2H₂O: C, 43.81; H, 4.48; N, 6.66. Found: C, 43.22; H, 4.13; N, 6.27%.

**Synthesis of [Ru₂(L1)(dcbpy)₂Cl₄] (dcbpy** = **4,4'-dicarboxy-2,2'-bipyridine):** The synthesis and workup of this reaction was performed under reduced light in order to avoid possible cis - trans isomerization. Ru₂(L1)Cl₄(dmso)₄ (378 mg, 0.3 mmol) was dissolved in dimethylformamide (100 mL) to which the dcbpy **(4,4-dicarboxy-2,2-**bipyridine) ligand (147 mg, 0.6 mmol) was added. The reaction flask was wrapped with aluminum foil and refluxed under argon atmosphere for 4 h. The reaction mixture was cooled to 25°C and filtered. The filtrate was evaporated to dryness, and the solid was dissolved in methanol and filtered. To this methanolic solution was added diethyl ether in order to precipitate the complex [Ru₂(L1)(dcbpy)₂Cl₄]. The crude complex was re-crystallized from a methanol, diethyl ether, and petroleum ether mixture. The resulting microcrystalline powder was collected on a sintered glass crucible and dried under vacuum. 345 mg, 78% yield. Anal. Calc. For C₆₂H₄₄N₁₀O₈RuCl₄.4H₂O: C, 50.56; H, 3.56; N, 9.51. Found: C, 50.44; H, 3.31; N, 9.48%.

**Synthesis of [Ru₂(L1)(dcbpy)₂(NCS)₄]:** KSNC (1.164 g, 12 mmol) was dissolved in 5 mL of distilled water and transferred into a three - necked flask. To this solution was added DMF (30 mL), and the resultant mixture was then purged with argon for 5 min. [Ru₂(L1)(dcbpy)₂Cl₄] (221 mg, 0.15 mmol) was introduced as a solid into the flask under reduced light, followed by another 20 mL of DMF solvent. The flask was covered with aluminum foil and refluxed for 5 h. The reaction mixture was allowed to cool and then filtered through a sintered glass (G4) crucible. The DMF and water solvents were removed using a rotary evaporator under vacuum. To the resulting viscous liquid was added 10 mL of water. To this aqueous solution was added ∼ 2 mL of 0.05 M NaOH to give a dark purple homogeneous solution. The solution was filtered and the pH lowered to 3 with a 0.5 M HNO₃ acid solution. The resulting dense precipitate was placed in a refrigerator for 12 h at 0 °C. After allowing it to warm to room temperature, the solid was collected on a sintered glass crucible by suction filtration. It was washed (4 × 20 mL) with pH 3.5 water that was acidified with the same acid as used previously and air - dried under vacuum. Purification process was carried out in MeOH / Et₂O. 182 mg, 81% yield. Anal. Calc. For C₆₆H₄₄N₁₄O₈Ru₂S₄: C, 53.15; H, 2.97; N, 13.15. Found: C, 52.97; H, 2.88; N, 13.08%. FT-IR (KBr, cm⁻¹): 3439, 2070, 1717, 1627, 1461, 1366, 1292, 1269, 865, 784. ¹H NMR (DMSO) δ ppm: 9.51 (d, J= 6 Hz, 2H, NC*H*CH), 9.18 (d, *J* = 4 Hz, 2H, NC*H*CH), 8.43 (d, *J* = 4.8 Hz, 2H, CC*H*C), 8.27 (d, *J* = 6 Hz, 2H, CHC*H*C), 8.12 (d, *J* = 6.8 Hz, 2H, CC*H*CH), 8.01 (s, 2H, CC*H*C), 7.86 (d, *J* = 6 Hz, 2H, NC*H*CH), 7.66 (d, *J =* 4.4 Hz, 2H, CC*H*CH), 7.58 (d, *J* = 4 Hz, 2H, NC*H*CH), 7.50 (s, 4H, CC*H*C), 7.45 (q, *J* = 2.8 Hz, 2H, C*H*CHCH), 7.32 (s, 2H, CC*H*CH), 6.97 (q, J= 2.4 Hz, 2H, C*H*CHCH), 2.25 (s, 12H, Ar-C*H*₃). ¹³C NMR δ ppm: 171.6 (*C*OOH), 171.1 (*C*OOH), 164.7 (C*C*NC), 163.5 (N*CC*N), 162.9 (N*CC*N), 152.2 (N*C*HCH), 151.8 (N*C*HCH), 146.4 (CN*C*), 139.3 (N*C*HCH), 138.8 (N*C*HCH), 135.4 (CH*C*HC), 135.0 (CH*C*CH), 134.8 (CH*C*HC), 134.6 (CH*C*CH), 132.6 (CH*C*HC), 132.2 (CH*C*HC), 131.6 (N*C*S), 130.8 (C*C*HC), 130.5 (C*C*HC), 129.7 (*C-C*), 129.1 (H₃C*C*), 128.3 (CH*C*CN), 128.0 (CH*C*CN), 124.8 (C*C*HC), 118.7 (CH*C*HCH), 118.4 (CH*C*HCH), 18.2 (C*C*H₃).

### Preparation of [Ru(L4)(dcbpy)(NCS)₂], [K45]:

[RuCl₂(*p-*cymene)]₂ (0.1 g, 0.16 mmol) was dissolved in DMF (50 mL) and 4,5-diazafluoren-9-one (0.0585 g, 0.32 mmol) then added. The reaction mixture was heated to 60°C under argon for 4 h with constant stirring. To this reaction flask dcbpy (0.08 g, 0.32 mmol) was added and refluxed for 4 h. Finally, excess of NH₄SCN (0.988 g, 13 mmol) was added to the reaction mixture and the reflux continued for another 4 h. The reaction mixture was cooled down to room temperature and the solvent was removed by using a rotary evaporator under vacuum. Water was added to the flask and the insoluble solid was collected on a sintered glass crucible by suction filtration. The solid was dried under vacuum and then re-crystallized from MeOH / Et₂O. In the second step, it was refluxed for about 2 h in 5 mL triethylenglycol containing a catalytic amount of *p-*toluenesulfonic acid monohydrate. The solution was filtered hot. After the solution stood overnight in the refrigerator, a solid precipitated. The solid was filtered off and dried under vacuum. On a Sephadex LH-20 column the crude complex was purified with methanol as an eluent. 91 mg, 73.5% yield. Anal. Calc. For RuC₃₃H₂₈N₄O₈S₂: C, 51.22; H, 3.65; N, 7.24. Found: C, 51.07; H, 3.49; N, 7.13%. FT-IR (KBr, cm⁻¹): 3414, 3109, 2789, 2112, 2061, 1711, 1595, 1401, 1371, 786. ¹H NMR (DMSO) δ ppm: 9.50 (d, *J* = 6 Hz, 1H, NC*H*CH), 9.27 (d, *J* = 5.2 Hz, 1H, NC*H*CH), 8.44 (s, 1H, CC*H*C), 8.25 (s, 1H, CC*H*C), 8.01 (d, *J* = 7.4 Hz, 1H, CHC*H*C), 7.84 (d, *J* = 7.4 Hz, 1H, CHC*H*C), 7.65 (d, *J* = 5.2 Hz, 1H, NC*H*CH), 7.61 (d, J= 6 Hz, 1H, CC*H*CH), 7.58 (d, *J* = 4 Hz, 1H, NC*H*CH), 7.13 (q, *J* = 5.2 Hz, 1H, CHC*H*CH), 7.02 (d, *J* = 1.6 Hz, 1H, CC*H*CH), 6.49 (q, *J* = 5.2 Hz, 1H, CHC*H*CH), 4.11 (q, *J* = 4.10 Hz, 4H, OC*H*₂CH₂O), 3.87 (m, *J* = 4.39 Hz, 4H, OC*H*₂C*H*₂O), 3.70 (q, *J* = 4.97 Hz, 4H, OCH₂C*H*₂O). ¹³C NMR (DMSO) δ ppm: 172.6 (*C*OOH), 172.3 (*C*OOH), 163.9 (N*CC*N), 156.5 (N*CC*N), 155.8 (N*C*HCH), 155.3 (N*C*HCH), 143.2 (N*C*HCH), 142.7 (N*C*HCH), 140.4 (CH*C*HC), 140.0 (CH*C*CH), 139.8 (CH*C*HC), 139.6 (CH*C*CH), 135.9 (C*C*HC), 135.6 (C*C*HC), 133.2 (N*C*S), 131.6 (CH*C*HC), 131.2 (CH*C*HC), 129.8 (*C*CO₂C), 129.6 (CCO₂*C*) 125.1 (CH*C*HCH), 124.6 (CH*C*HCH), 73.9.70 (O*C*O), 71.4, 71.0, 70.8, 70.4, 69.9, 69.7 (*C_{crown}*)

### Preparation of [Ru(L5)(dcbpy)(NCS)₂], [K47]:

[RuCl₂(*p-*cymene)]₂ (0.1 g, 0.16 mmol) was dissolved in DMF (50 mL) and 4,5-diazafluoren-9-one (0.0585 g, 0.32 mmol) then added. The reaction mixture was heated to 60°C under argon for 4 h with constant stirring. To this reaction flask dcbpy (0.08 g, 0.32 mmol) was added and refluxed for 4 h. Finally, excess of NH₄SCN (0.988 g, 13 mmol) was added to the reaction mixture and the reflux continued for another 4 h. The reaction mixture was cooled down to room temperature and the solvent was removed by using a rotary evaporator under vacuum. Water was added to the flask and the insoluble solid was collected on a sintered glass crucible by suction filtration. The solid was dried under vacuum and then re-crystallized from MeOH / Et₂O. In the second step the solid, a few drops glacial acetic acid and N-(3-aminopropyl)imidazole (0.05 mL, 0.4 mmol) were refluxed for about 6 h in 5 mL toluene. To this solution, 1-iodobutane (0.046 mL, 0.4 mmol) was added and the reflux continued for another 12 h. The solution was filtered hot, dried under vacuum and re-crystallized from MeOH / Et₂O. On a Sephadex LH-20 column the crude complex was purified with methanol as an eluent. 92.7 mg, 62% yield. Anal. Calc. For RuC₃₅H₃₂N₉O₄S₂I: C, 44.97; H, 3.45; N, 13.49. Found: C, 44.57; H, 3.29; N, 13.17%. ¹H NMR (DMSO) δ ppm: 10.25 (s, 1H, N*CH*N), 9.48 (d, *J* = 6 Hz, 1H, NCHCH), 9.23 (d, *J* = 5.2 Hz, 1H, NC*H*CH), 8.42 (s, 1H, CC*H*C), 8.20 (s, 1H, CC*H*C), 7.98 (d, *J =* 7.4 Hz, 1H, CHC*H*C), 7.80 (d, *J =* 7.4 Hz, 1H, CHC*H*C), 7.62 (d, *J* = 5.2 Hz, 1H, NC*H*CH), 7.58 (d, *J* = 6 Hz, 1H, CC*H*CH), 7.51 (d, *J* = 4 Hz, 1H, NC*H*CH), 7.26 (d, *J* = 1.4 Hz, 1H, NC*H*CHN), 7.21 (d, *J* = 1.8 Hz, 1H, NCHC*H*N), 7.11 (q, *J* = 5.2 Hz, 1H, CHC*H*CH), 6.93 (d, *J* = 1.6 Hz, 1H, CC*H*CH), 6.45 (q, *J* = 5.2 Hz, 1H, CHC*H*CH). 4.27 (t, *J* = 7.4 Hz, 2H, NC*H₂*CH₂-), 4.07 (t, *J* = 7.2 Hz, 2H, NCH₂CH₂C*H*₂N), 3.82 (t, *J =* 7.4 Hz, 2H, NC*H*₂CH₂CH₂N), 2.39 (m, *J* = 5.4 Hz, 2H, NCH₂C*H*₂CH₂N), 1.87 (m, 2H, *J=* 5.2 Hz, NCH₂C*H*₂CH₂CH₃), 1.37 (q, 2H, J= 7.5 Hz, NCH₂CH₂C*H*₂CH₃), 0.93 (t, 3H, *J* = 7.5 Hz, -CH₂C*H*₃). ¹³C NMR (DMSO) δ ppm: 173.5 (COOH), 173.3 (COOH), 169.6 (C*CN*C),163.5 (N*CC*N), 156.3 (N*CC*N), 155.7 (NCHCH), 155.1 (NCHCH), 143.2 (NCHCH), 142.6 (NCHCH), 140.4 (CHCHC), 140.0 (CHCCH), 139.6 (CHCHC), 139.3 (CHCCH), 136.91 (NCHN), 135.8 (CCHC), 135.5 (CCHC), 132.8 (NCS), 131.5 (CHCHC), 131.2 (CHCHC), 130.1 (CCNC), 129.8 (CCNC), 125.1 (CHCHCH), 124.6 (CHCHCH), 123.90 (NCHCHN), 122.63 (NCHCHN), 56.58 (NCH₂CH₂CH₂N), 49.58 (N*C*H₂CH₂CH₂N), 48.96 (NCH₂CH₂CH₂CH₃), 26.79 (NCH₂*C*H₂CH₂CH₃), 21.36 (NCH₂CH₂CH₂CH₃), 20.14 (NCH₂*C*H₂CH₂N), 14.73 (NCH₂CH₂CH₂CH₃).

According to this invention there is provided a photoelectrochemical solar cell comprising:
- An electrically conductive transparent oxide (6) coated substrate preferably glass or polymer (1 and 7),
- Mesoporous nanocrystalline metal oxide layer (5) coated on electrically conductive transparent oxide coated substrate (6) named "photoanode" or "working electrode"
- " Novel Sensitizers" named photoactive dye preferably ruthenium complexes (4) anchored on mesoporous nanocrystalline metal oxide layer (5),
- second electrically conductive transparent oxide coated electrode preferably glass or polymer coated with thin catalyst layer preferably platinum (2) called "Counter electrode"
- Solution of redox couple preferably triiodide / iodine couple (3) filled between working (6) electrode and counter electrode (2).

The innovation in the photo-electrochemical cell described above is the sensitizer. The detailed description about the novel sensitizers is given above.

TiO₂ paste for preparing nanocrystalline TiO₂ layer (5) was synthesized according to Wang et al.as fallows:
An amount of 12 g (0.2 mol) of acetic acid was added drop wise to 58.6 g (0.2 mol) of titanium iso-propoxide under stirring at room temperature. The modified precursor was stirred for about 15 min and poured into 290 mL water as fast as possible with vigorous stirring (700 rpm). A white precipitate was instantaneously formed. One hour stirring was performed to achieve a complete hydrolysis reaction. After adding a quantity 5.4 mL of 65% nitric acid, the mixture was heated from room temperature to 78°C within 40 min and peptized for 75 min. Then, water was added to the cooling liquid mixture to adjust the volume to be 370 mL. The resultant mixture was kept in a 570 mL titanium autoclave and heated at 250°C for 12 h. After that, 2.4 mL of 65% nitric acid was added and dispersed with a 200 W ultrasonic titanium probe at a frequency of 15 pulses every second. The resultant colloidal solution was concentrated with a rotary-evaporator to contain 18% TiO₂. Finally, it was centrifuged to remove nitric acid and washed with ethanol three times to produce a colloidal solution containing 40% TiO₂ and 4% water in ethanol. 45 g of 10% (w/w) of ethyl cellulose solution in ethanol and 79,5g terpineol were added to the TiO₂ paste and dispersed by ultrasonic probe. All of the ethanol in the paste was removed with rotary evaporator. Final paste consist of 16% of 20 nm particle size TiO₂, 4.5% ethyl cellulose and 79.5% terpineol.

Prepared paste was deposited on electrically conductive transparent oxide coated glass substrate by screen printing. Coated substrates sintered in the oven at 450 °C for 60 minutes with 10 °C/min heating rate. The porosity and average pore size of the transparent layer were measured with a nitrogen adsorption apparatus to be 63% and 22 nm, respectively.

### APPLICATION EXAMPLE

Nanocrystalline TiO₂ layer (5) coated electrically conductive glass (6) electrodes with thickness 5 to 15 microns heated up to 100°C for 10 minutes and than were immersed in 0.3 mM acetonitrile : tert-butanol (1:1) to each solution of K-20, K-28, K-45, K-47 and K-26 seperately for 3 to 12 hours. At the end of this time electrodes rinsed with pure acetonitrile and kept in the nitrogen atmosphere. The second electrically conductive oxide coated glass electrode used as a counter electrode (2). One or two drop of 0.5 to 5 percent (w/w) of hydrogenehexachloroplatinate solution in 2-propanol dropped on the counter electrode and first dried at room temperature then in the oven at 400 °C for 10 to 30 minutes.

Photo electrochemical cells were prepared in sandwich geometry. Platinized counter electrode (2) was put on the top of the TiO₂ / Dye coated electrode as shown in Figure-1. Thermoplastic Surlyn-1702 (DuPont) frame with thickness 10 to 100 microns was used as a spacer and sealant between two electrodes. Prepared cells were sealed by heating at 100°C. Redox couple containing electrolyte was filled into the space created by Surlyn-1702 between electrodes under vacuum using small hole pre-drilled on counter electrode. After filling the electrolyte (3), small hole was sealed again using peace of Surlyn-1702 and peace of cover glass. The electrolyte consisted of 0,6M N-methyl-N-butyl imidazolium iodide (BMII) + 0.1 M LiI +0.05M I₂ in acetonitrile.

Prepared photo electrochemical cells were characterized by current-voltage (I-V) measurement and measurement of incident photon to current conversion efficiency (IPCE) spectra. All current-voltage (I-V) measurements were done under 100 mW/cm² light intensity and AM1.5 conditions. The overall energy conversion efficiency, η, has been calculated using the equation, η = *Pₘₐₓ*/ *P_{light}* =*(VₘₚₚIₘₚₚ)* / *P_{light}* = *(V_{oc}I_{sc}FF)*/*P_{light}* , where V_{oc} (V) is open circuit voltage, I_{sc} (mA/cm²) is short circuit current, FF is fill factor, Pₘₐₓ (mW/cm²) is maximum power point, P_{light} (mW/cm²) is incident light power, Vₘₚₚ and Iₘₚₚ are voltage and current at the point of maximum power output of cell, respectively.

The incident photon to current conversion efficiency (IPCE), defined as the number of electrons generated by light in the external circuit divided by the number of incident photons is plotted as function of excitation wavelength. IPCE can be calculated by means of following equation, *IPCE [%]*=*1240 Isc* / *(*λ*I),* where I_{sc} (mA/cm²) is the short-circuit photocurrent density for monochromatic irradiation and λ (nm) and I (W/m²] are the wavelength and the intensity of the monochromatic light.

The photovoltaic parameters of the photo electrochemical cell fabricated with K-20, K-45and K-47 under standard conditions are given in the table below. the The measured incident photon to current conversion efficiency (IPCE) at 520 nm of K-20 was 70% (Figure 2).

**Table-1: I-V measurement results of DSSs sensitized with K-20, K-45 and K-47 and standard dye Z-907 under illumination with 100 mW/cm² light intensity by AM 1.5 solar simulator.**

| | **K-20** | **K-45** | **K-47** |
|---|---|---|---|
| **V_{oc} [V]** | 0.650 | 0.39 | 0.55 |
| **I_{sc} [mA/cm²]** | 13.99 | 9.96 | 8.54 |
| **Vₘₚₚ [V]** | 0.501 | 0.26 | 0.30 |
| **Iₘₚₚ [mA/cm²]** | 12.7 | 8.07 | 6.40 |
| **MPP [mW]** | 6.58 | 2.09 | 1.92 |
| **FF** | 0.72 | 0.54 | 0.40 |
| **η [%]** | 6.58 | 2.1 | 1.92 |

## Claims

1. A Ruthenium complex represented by the formula [RuL¹L²X₂]_{2,} 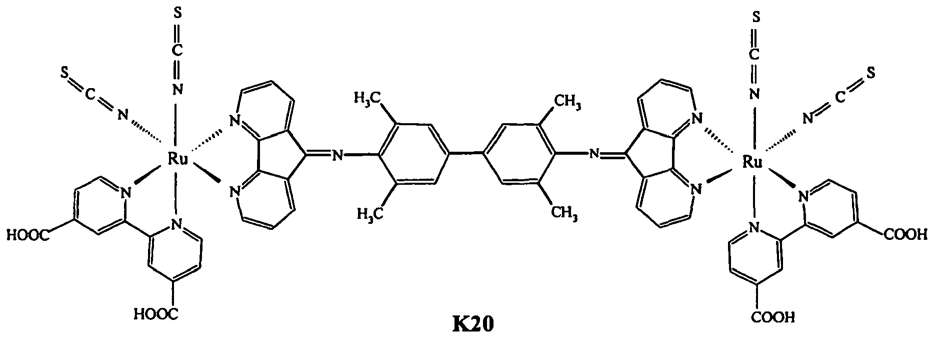 Where L1 is 4,4'-dicarboxy-2,2'-bipyridine, L2 is [3,3',5,5'-tetramethyl-*N*⁴,*N*⁴-di(5*H-*pyrido[3',2':4,5]cyclopenta[1,2-*b*]pyridin-5-ylidene)[1,1'-biphenyl]-4,4'-diamine] and X is isothiocyanide.

2. A Ruthenium complex represented by the formula RuL¹L²X₂, 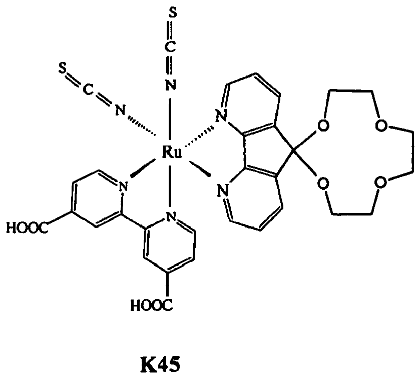 L1 is 4,4'-dicarboxy-2,2'-bipyridine, L2 is spiro[4,5-diazafluorene-9,1'-[2,5,8,11]tetraoxacycloundecane] compound and X is isothiocyanide.

3. A Ruthenium complex represented by the formula RuL¹L²X₂, 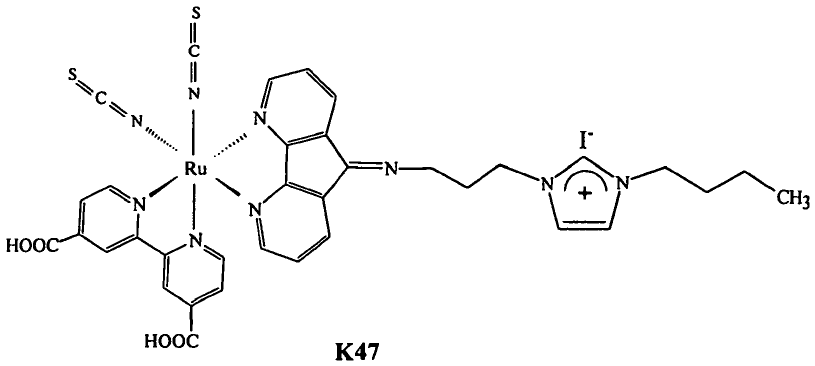 where L1 is 4,4'-dicarboxy-2,2'-bipyridine, L2 is N-5H-pyrido[3',2':4,5]cyclopenta[1,2-bipyridin-5-ylidene- 3-(3-butyl-2,3-dihydro-1H-pyrrole-1-yl)propan-1-amin and X is isothiocyanide.

4. A dye sensitized oxide semiconductor electrode comprising an electrically conducting substrate, an oxide semiconductor film on a said electrically conductive substrate and a ruthenium complex according to claims 1 to 3 adsorbed on the surface of said film.

5. A photo electrochemical cell comprising a dye sensitized oxide semiconductor electrode according to claim 4, a counter electrode and electrolyte containing redox couple

## Patentansprüche

1. Rutheniumkomplex, der durch die Formel [RuL¹L²X₂]₂ dargestellt ist, 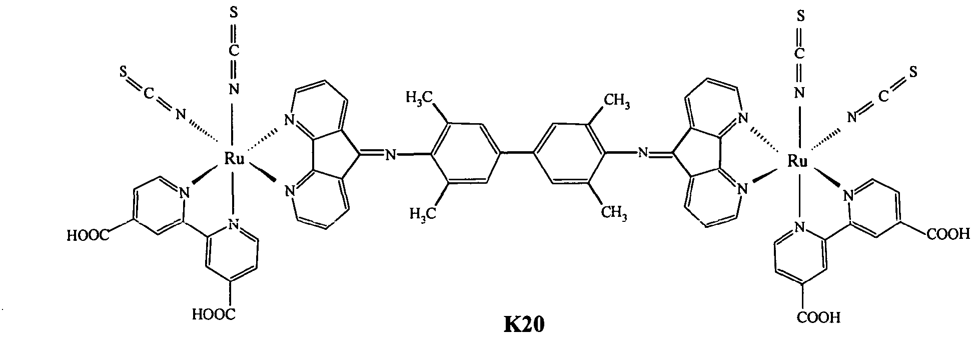 wobei L1 4,4'-Dicarboxy-2,2'-bipyridin ist, L2 [3,3',5,5'-Tetramethyl-*N⁴,N⁴'*-di(5*H-*pyrido[3',2':4,5]cyclopenta[1,2*-b*]pyridin-5-yliden)[1,1'-biphenyl]-4,4'-diamin] ist und X Isothiocyanid ist.

2. Rutheniumkomplex, der durch die Formel RuL¹L²X₂ dargestellt ist, 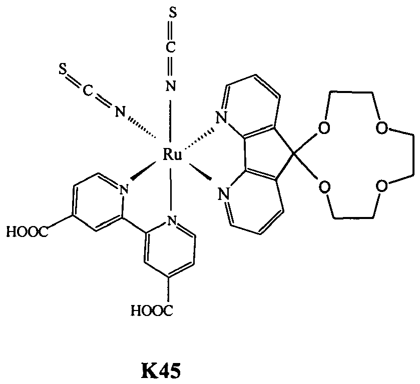 wobei L1 4,4'-Dicarboxy-2,2'-bipyridin ist, L2 Spiro[4,5-diazafluoren-9,1'-[2,5,8,11]tetraoxacycloundecan]-Verbindung ist und X Isothiocyanid ist.

3. Rutheniumkomplex, der durch die Formel RuL¹L²X₂ dargestellt ist, 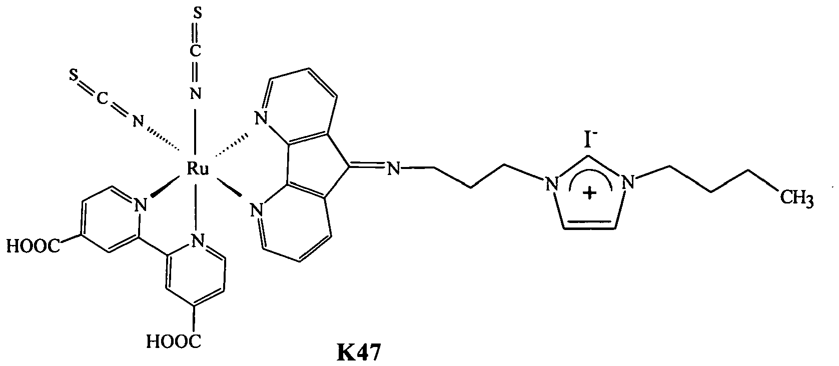 wobei L1 4,4'-dicarboxy-2,2'-bipyridin ist, L2 N-5H-pyrido[3',2':4,5]cyclopenta[1,2-bipyridin-5-yliden-3-(3-butyl-2,3-dihydro-1H-pyrrol-1-yl)propan-1-amin ist und X Isothiocyanid ist.

4. Farbstoffsensibilisierte Oxidhalbleiterelektrode, umfassend ein elektrisch leitendes Substrat, eine Oxidhalbleiterschicht auf dem elektrisch leitenden Substrat und einen Rutheniumkomplex gemäß den Ansprüchen 1 bis 3, der an der Oberfläche der genannten Schicht adsorbiert ist.

5. Fotoelektrochemische Zelle, umfassend eine farbstoffsensibilisierte Oxidhalbleiterelektrode gemäß Anspruch 4, eine Gegenelektrode und einen Elektrolyt mit einem Redoxpaar.

## Revendications

1. Un complexe de Ruthénium représenté par la formule [RuL¹L²X₂]₂, 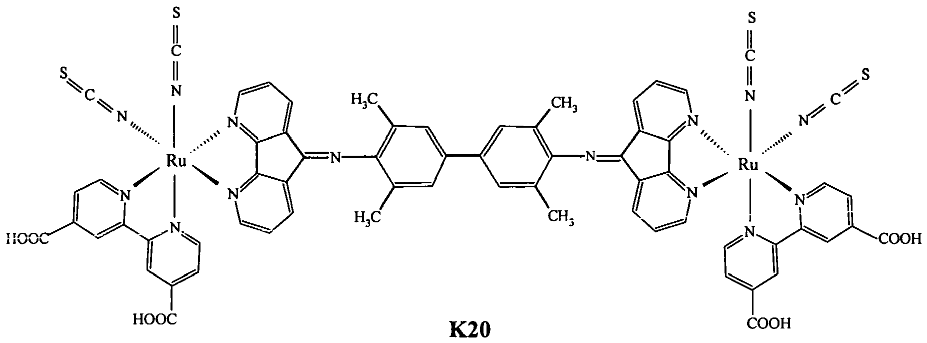 où L1 est 4,4'-dicarboxy-2,2'-bipyridine, L2 est [3,3,5,5'-tétraméthyl-*N*⁴,*N*⁴'-di(5*H-*pyrido[3',2':4,5]cyclopenta[1,2*-b*]pyridine-5-ylidène)[1,1'-biphényl-4,4'-diamine] et X est isothiocyanure.

2. Un complexe de Ruthénium représenté par la formule RuL¹L²X₂, 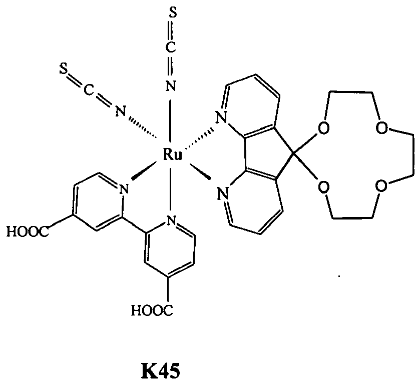 L1 est 4,4'-dicarboxy-2,2'-bipyridine, L2 est un composé spiro[4,5-diazafluorène-9,1'-[2,5,8,11]tetraoxacycloundécane] et X est isothiocyanure.

3. Un complexe de Ruthénium représenté par la formule RuL¹L²X₂, 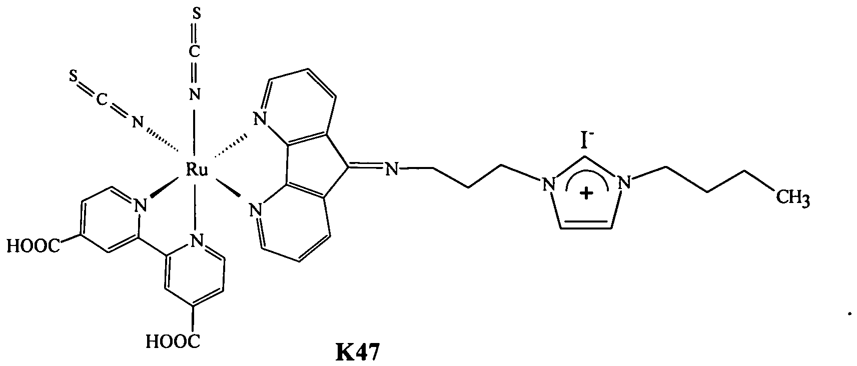 où L1 est 4,4'-dicarboxy-2,2'-bipyridine, L2 est N-5H-pyrido[3,2':4,5]cyclopenta[1,2-bipyridin-5-ylidene- 3-(3-butyle-2,3-dihydro-1H-pyrrole-1-yl)propan-1-amine et X est isothiocyanure.

4. Electrode d'oxyde semi-conducteur sensibilisé par un colorant comprenant un substrat conducteur d'électricité, un film d'oxyde semi-conducteur sur ledit substrat conducteur d'électricité et un complexe ruthénium selon les revendications 1 à 3 absorbé sur la surface dudit film.

5. Une cellule électrochimique comprenant une électrode d'oxyde semi-conducteur sensibilisé par un colorant selon la revendication 4, une électrode auxiliaire et électrolyte contenant un couple redox.
